# DEMANDE DE BREVET EUROPEEN

(11) **EP 4 535 640 A1**
(43) Date de publication de la demande: **09.04.2025**
(21) Numéro de dépôt: 24203757.0
(22) Date de dépôt: 30.09.2024
(51) Int. Cl.: H02M 7/5387, H02M 1/32

(54) **COMPOSANT ÉLECTRONIQUE DESTINÉ À ÊTRE EMBARQUÉ SUR UN VÉHICULE**

(30) Priorité: 05.10.2023 FR 2310670
(71) Demandeur: Valeo eAutomotive Germany GmbH, 91056 Erlangen (DE)
(72) Inventeur: BENDANI, Larbi, 95892 Cergy Pontoise (FR); FIORINA, Jean-Noel, 95892 Cergy Pontoise (FR); SEBIANE, Sofiane, 95892 Cergy Pontoise (FR)
(74) Mandataire: Valeo Powertrain Systems

(57) **Abrégé**

Composant électronique (1) pour la charge d'une unité de stockage d'énergie électrique, comprenant :
- un connecteur (3) apte à être branché à un réseau électrique apte à fournir une tension alternative triphasée,
- un onduleur/redresseur (6), comprenant trois bras de commutation (7) montés en parallèle, chaque bras de commutation comprenant deux interrupteurs (8) disposés de part et d'autre d'un point milieu (9) apte à être connecté à une phase respective de la tension alternative,
- un quatrième bras de commutation (10) monté en parallèle des bras de commutation (7) de l'onduleur/redresseur (6), ce quatrième bras de commutation (10) comprenant deux interrupteurs (11) disposés de part et d'autre d'un quatrième point milieu (12) apte à être connecté au neutre du réseau électrique, et
- une branche (13) montée en parallèle desdits bras de commutation, comprenant deux condensateurs (14) disposés de part et d'autre d'un cinquième point milieu (15), et une résistance de mesure (17) montée en série avec l'un des condensateurs (14),

la branche (13) et les bras de commutation (7, 10) étant montés entre deux bornes à potentiel continu,
caractérisé par le fait qu'un premier interrupteur (20) est monté en parallèle de la résistance de mesure (17) et qu'un deuxième interrupteur (21) est monté en série entre le quatrième (12) et le cinquième (15) point milieu.

## Description

La présente invention concerne un composant électronique destiné à être embarqué sur un véhicule. Un tel composant assure par exemple l'alimentation électrique d'une unité de stockage d'énergie électrique de véhicule, et il est encore appelé « chargeur » de cette d'unité de stockage d'énergie électrique. L'unité de stockage d'énergie électrique est par exemple une batterie, pouvant présenter une tension nominale supérieure à 60V, par exemple supérieure ou égale à 300V, à 400V, à 800V, voire à 1000V. Ce composant comprend dans un exemple connu :
- un onduleur/redresseur recevant en entrée une tension alternative d'une borne de charge et fournissant en sortie une tension continue, et
- un convertisseur DC/DC disposé en aval de l'onduleur/redresseur et connecté à l'unité de stockage d'énergie électrique.

Un tel onduleur/redresseur met en oeuvre une pluralité d'interrupteurs électroniques com-mandables tels que des transistors MOSFET ou des IGBT. Une défaillance dans l'un de ces interrupteurs électroniques peut conduire à l'existence d'un court-circuit aux bornes de cet interrupteur électronique commandable. Il existe un risque de faire disjoncter la borne de charge connectée au composant électronique, lorsqu'un tel court-circuit existe. Par ailleurs, si le composant électronique n'est pas mis en état hors-service, il existe un risque que lors de sa prochaine connexion à une autre borne de charge, cette autre borne disjoncte elle aussi. Pour éviter un tel risque, il est connu de disposer des fusibles entre l'onduleur/redresseur et le connecteur permettant la connexion du composant électronique à la borne de charge. L'emploi de fusibles génère un surcoût et peut générer un encombrement additionnel. Par ailleurs, l'emploi de fusibles génère des pertes et un échauffement.

Il existe un besoin pour améliorer encore de tels composants en remédiant à tout ou partie des inconvénients ci-dessus.

L'invention a pour but de répondre à ce besoin et elle y parvient, selon l'un de ses aspects, à l'aide d'un composant électronique pour la charge d'une unité de stockage d'énergie électrique, comprenant :
- un connecteur apte à être branché à un réseau électrique apte à fournir une tension alternative triphasée,
- un onduleur/redresseur, comprenant trois bras de commutation montés en parallèle, chaque bras de commutation comprenant deux interrupteurs disposés de part et d'autre d'un point milieu apte à être connecté à une phase respective de la tension alternative,
- un quatrième bras de commutation monté en parallèle des bras de commutation de l'onduleur/redresseur, ce quatrième bras de commutation comprenant deux interrupteurs disposés de part et d'autre d'un quatrième point milieu apte à être connecté au neutre du réseau électrique, et
- une branche montée en parallèle desdits bras de commutation, comprenant : deux condensateurs disposés de part et d'autre d'un cinquième point milieu, et une résistance de mesure montée en série avec l'un des condensateurs,
la branche et les bras de commutation étant montés entre deux bornes à potentiel continu, caractérisé par le fait qu'un premier interrupteur est monté en parallèle de la résistance de mesure et qu'un deuxième interrupteur est monté en série entre le quatrième et le cinquième point milieu.

La présence de la résistance de mesure en série avec l'un des condensateurs appartenant à la branche montée en parallèle des bras de commutation de l'onduleur/redresseur permet de réaliser plusieurs tests permettant de diagnostiquer l'existence d'un court-circuit aux bornes d'un interrupteur du composant, qu'il s'agisse d'un interrupteur de l'onduleur/redresseur ou de l'un du premier et du deuxième interrupteur précités, notamment. Comme on le verra également par la suite, d'autres court-circuits dans le composant peuvent être détectés à l'aide de tests effectués en rapport avec cette résistance de mesure. On évite ainsi de faire disjoncter la borne de charge sans qu'il soit nécessaire d'avoir recours à des fusibles.

La présence du quatrième bras de commutation en parallèle des bras de commutation de l'onduleur/redresseur et dont le point milieu est apte à être connecté au neutre permet d'utiliser ce quatrième bras de commutation pour un redressement monophasé lorsque la borne de charge fournit une tension monophasée.

On bénéficie ainsi d'un composant permettant :
- une charge triphasée via les trois phases de la tension alternative et les trois bras de commutation de l'onduleur/redresseur, et
- une charge monophasée via le neutre de la tension alternative et le quatrième bras de commutation
composant dont l'état peut être testé pour éviter de faire disjoncter la borne de charge sans avoir recours à des fusibles. Le composant peut être dépourvu de tout fusible.

L'onduleur/redresseur peut être configuré pour exercer une correction du facteur de puissance de la tension alternative (PFC en anglais). L'onduleur/redresseur comprend par exemple des interrupteurs étant des transistors MOSFET et le quatrième bras de commutation comprend des interrupteurs étant des transistors IGBT. Le choix de ces interrupteurs pour le quatrième bras est particulièrement adapté à une tension alternative monophasée. Dans une variante, les interrupteurs de l'onduleur/redresseur et du quatrième bras de commutation sont de même type, par exemple des transistors IGBT uniquement ou des transistors MOSFET uniquement.

La résistance de mesure peut être montée en série avec le condensateur disposé entre le cinquième point milieu et celle des bornes à potentiel continu étant la masse. Cette position de la résistance de mesure permet que celle-ci soit associée à un potentiel électrique fixe, à savoir la masse.

En variante, la résistance de mesure peut être montée en série avec le condensateur disposé entre le cinquième point milieu et celle des bornes à potentiel continu étant à un potentiel électrique positif différent de la masse.

Chacun du premier et du deuxième interrupteur est par exemple un relais électrotechnique. L'invention n'est cependant pas limitée à un tel exemple, d'autres interrupteurs étant possibles, par exemple un relais statique à base de coupleurs optiques et/ou de transistor MOSFET et/ou de transistor IGBT.

Le composant électronique peut comprendre un convertisseur DC/DC monté en cascade avec le quatrième bras de commutation et la branche comprenant les deux condensateurs et la résistance de mesure.

Ce convertisseur DC/DC comprend par exemple une isolation galvanique, notamment via un transformateur. Ce transformateur est par exemple un transformateur monophasé ou triphasé. Ce convertisseur DC/DC comprend de façon connue :
- un onduleur/redresseur monté entre les deux bornes à potentiel continu et le primaire du transformateur, et
- un redresseur/onduleur ou un redresseur à diodes monté entre le secondaire du transformateur et l'unité de stockage d'énergie électrique. Lorsqu'un redresseur/onduleur est présent, il peut comprendre des transistors MOSFET permettant un redressement synchrone.

Le convertisseur DC/DC est par exemple un convertisseur résonant de type LLC ou CLLC.

Dans tout ce qui précède, la résistance de mesure peut être une résistance simple, c'est-à-dire une impédance dont la valeur de résistance reste constante. En variante, cette résistance de mesure peut être une thermistance. Il s'agit par exemple d'une thermistance à coefficient de température positif, encore appelée « PTC » en anglais. L'invention n'est pas limitée à une résistance, l'emploi d'une inductance étant envisageable

Chaque condensateur de la branche montée en parallèle des bras de commutation est par exemple un condensateur électrolytique, présentant par exemple une capacité comprise entre 100 µP et 1000 µP. Ces condensateurs traitent par exemple des courants basse fréquence.

En parallèle du quatrième bras de commutation peut également être monté un autre bras comprenant uniquement un condensateur. Il s'agit par exemple d'un condensateur dont la capacité est de l'ordre de quelques centaines de nF. Ce condensateur vise notamment à réduire l'ondulation haute fréquence. Ce condensateur est par exemple en polypropylène ou en céramique.

Dans tout ce qui précède, le composant peut comprendre une unité de contrôle configurée pour :
- effectuer une mesure d'une grandeur électrique associée à la résistance de mesure, et
- déterminer à l'aide de cette mesure l'existence de l'un des défauts suivants :
   - état en court-circuit du premier interrupteur,
   - état en court-circuit du deuxième interrupteur,
   - état en court-circuit d'un des interrupteurs du quatrième bras de commutation,
   - état en court-circuit d'un des interrupteurs d'un bras de commutation de l'onduleur/redresseur,
   - existence d'un court-circuit entre une phase de la tension alternative et le neutre, ou
   - existence d'un court-circuit entre deux des phases de la tension alternative, cette dernière étant notamment triphasée.

La réalisation de tout ou partie de ces tests permet de réaliser un diagnostic de l'état du composant électronique avant que celui-ci ne soit connecté au réseau électrique pour charger l'unité de stockage d'énergie électrique. Comme déjà mentionné, on détecte l'existence de court-circuits dans le composant.

La détermination du ou des défauts précités peut se faire alors qu'une tension, non obtenue par le connecteur, est appliquée aux bornes des bras de commutation. Cette tension est par exemple obtenue à partir de l'alimentation de l'unité de contrôle et peut avoir une valeur comprise entre 12V et 24V, par exemple égale à 18V ou 20V.

Le premier interrupteur peut former un interrupteur de pré-charge, tel qu'un relais de pré-charge. La résistance de mesure peut permettre de limiter le courant d'appel dans les condensateurs de la branche montée en parallèle des bras de commutation. Lors de la connexion du composant électronique au réseau électrique, le premier interrupteur peut être ouvert afin de limiter ce courant d'appel. Une fois la tension aux bornes des bras de commutation, et donc de ladite branche, comprise dans une plage de valeurs prédéfinie, par exemple entre 680V et 820V, le premier interrupteur peut être maintenu fermé, de manière à court-circuiter la résistance de mesure.

L'unité de contrôle peut comprendre un microcontrôleur, ou un circuit intégré par exemple un FPGA ou un ASIC.

L'unité de contrôle est par exemple configurée pour :
- effectuer une séquence de mesures de la grandeur électrique associée à la résistance de mesure et,
- déterminer à l'aide de ces mesures l'existence de plusieurs desdits défauts, une mesure étant associée à la détermination d'un ou plusieurs desdits défauts.

Selon cet aspect de l'invention, à l'aide d'une seule grandeur électrique associée à la résistance de mesure, répétée selon une séquence, on effectue tout ou partie des tests précités. Une seule mesure permet par exemple de déterminer un des défauts précités. En variante, plusieurs mesures peuvent être nécessaires pour déterminer l'existence de l'un des défauts précités. Par exemple, deux mesures peuvent être nécessaires pour déterminer l'existence d'un court-circuit entre deux des trois phases de la tension alternative ou l'état en court-circuit d'un des interrupteurs du quatrième bras de commutation.

La mesure est par exemple comparée par l'unité de contrôle à une valeur de référence et selon le résultat de cette comparaison, l'unité de contrôle détermine si le défaut existe ou non. D'un défaut à l'autre, la valeur de référence est par exemple différente.

La séquence de mesures peut comprendre un nombre de mesures permettant de déterminer l'existence de la totalité des défauts précités. Il est alors possible de se passer complètement de fusibles protégeant la borne de charge et le réseau électrique de l'existence de l'un de ces défauts.

Selon un exemple précis, l'unité de contrôle est configurée pour :
- effectuer une première mesure de la grandeur électrique associée à la résistance de mesure,
- déterminer sur la base de cette première mesure si le premier interrupteur est en état de court-circuit,
- lorsque le premier interrupteur n'est pas en état de court-circuit, effectuer une deuxième mesure de la grandeur électrique associée à la résistance de mesure,
- déterminer sur la base de cette deuxième mesure si le deuxième interrupteur est en état de court-circuit ou si l'un des interrupteurs du quatrième bras de commutation est en état de court-circuit,
- lorsque le deuxième interrupteur n'est pas en état de court-circuit ou que l'interrupteur du quatrième bras de commutation n'est pas en état de court-circuit, effectuer une troisième mesure de la grandeur électrique associée à la résistance de mesure,
- déterminer sur la base de cette troisième mesure si l'autre interrupteur du quatrième bras de commutation est en état de court-circuit,
- lorsque l'autre interrupteur du quatrième bras de commutation n'est pas en état de court-circuit, effectuer une quatrième mesure de la grandeur électrique associée à la résistance de mesure,
- déterminer sur la base de cette quatrième mesure si l'un des interrupteurs de l'onduleur/redresseur disposé entre un point milieu et l'une des bornes à potentiel continu est en état de court-circuit,
- lorsqu'aucun des interrupteurs de l'onduleur/redresseur disposé entre un point milieu et l'une des bornes à potentiel continu n'est en état de court-circuit, effectuer une cinquième mesure de la grandeur électrique associée à la résistance de mesure,
- déterminer sur la base de cette cinquième mesure si l'un des interrupteurs de l'onduleur/redresseur disposé entre un point milieu et l'autre des bornes à potentiel continu est en état de court-circuit,
- lorsqu'aucun des interrupteurs de l'onduleur/redresseur disposé entre un point milieu et l'autre des bornes à potentiel continu n'est en état de court-circuit, effectuer une sixième mesure de la grandeur électrique associée à la résistance de mesure,
- déterminer sur la base de cette sixième mesure si une phase de la tension alternative est en court-circuit avec le neutre,
- lorsqu'aucune phase de la tension alternative n'est en court-circuit avec le neutre, effectuer une septième mesure de la grandeur électrique associée à la résistance de mesure,
- déterminer sur la base de cette septième mesure si un court-circuit existe entre la première phase et la deuxième phase de la tension alternative,
- lorsqu'aucun court-circuit n'est détecté entre la première phase et la deuxième phase de la tension alternative, effectuer une huitième mesure de la grandeur électrique associée à la résistance de mesure,
- déterminer sur la base de cette huitième mesure si un court-circuit existe entre la première phase et la troisième phase de la tension alternative,
- lorsqu'aucun court-circuit n'est détecté entre la première phase et la troisième phase de la tension alternative, effectuer une neuvième mesure de la grandeur électrique associée à la résistance de mesure,
- déterminer sur la base de cette neuvième mesure si un court-circuit existe entre la deuxième phase et la troisième phase de la tension alternative.

La réalisation de ces neuf mesures permet par exemple de vérifier l'ensemble des défauts de court-circuits susceptibles de se produire dans l'onduleur/redresseur, le quatrième bras de commutation et la branche précitées.

Ces neufs mesures peuvent être effectuées dans l'ordre selon lequel elles ont été exposées ci-dessus.

Lorsque le composant comprend un convertisseur DC/ DC comme mentionné précédemment, l'unité de contrôle peut être configurée pour effectuer au moins une mesure additionnelle de la grandeur électrique associée à la résistance de mesure pour déterminer l'état en court-circuit d'un interrupteur du convertisseur DC-DC.

La grandeur électrique associée à la résistance de mesure est par exemple la tension aux bornes de cette résistance de mesure. Ainsi, en ne mesurant que la tension aux bornes de la résistance de mesure, on détermine l'existence de tout ou partie des défauts précités.

Dans tout ce qui précède, le composant peut comprendre un étage de filtrage du courant alternatif disposé en série entre le connecteur et l'onduleur/redresseur. Cet étage de filtrage permet par exemple, lorsque la tension alternative est polyphasée, un filtrage du courant de mode commun et/ou un filtrage du courant différentiel.

Dans tout ce qui précède, le composant peut comprendre un étage de filtrage du courant continu disposé en série entre le convertisseur DC/DC et l'unité de stockage d'énergie électrique.

Dans tout ce qui précède, la tension du réseau peut présenter une fréquence de 50 Hz ou 60 Hz et une valeur efficace de 230V ou 240V. En variante, la tension du réseau peut être monophasée.

Dans tout ce qui précède, l'unité de stockage d'énergie électrique est par exemple une batterie, pouvant présenter une tension nominale supérieure à 60V, par exemple supérieure ou égale à 300V, à 400V, à 800V, voire à 1000V.

Dans tout ce qui précède, le composant peut permettre de charger l'unité de stockage d'énergie électrique avec une puissance de 7kW, 11kW ou 22kW, voire plus.

Le composant électronique peut être regroupé dans un même boîtier ou non avec un convertisseur DC/DC assurant une conversion de tension entre la tension aux bornes de l'unité de stockage d'énergie électrique, dite « haute tension », et la tension du réseau de bord, dite « basse tension ». Comme déjà mentionné, la haute tension est par exemple supérieure à 60V, par exemple supérieure ou égale à 300V, à 400V, à 800V, voire à 1000V tandis que la basse tension est par exemple égale à 12V ou à 4SV.

L'invention a encore pour objet, selon un autre de ses aspects, un procédé, mis en oeuvre dans le composant précité, de détection de l'un au moins des défauts suivants :
- état en court-circuit du premier interrupteur,
- état en court-circuit du deuxième interrupteur,
- état en court-circuit d'un des interrupteurs du quatrième bras de commutation,
- état en court-circuit d'un des interrupteurs d'un bras de commutation de l'onduleur/redresseur,
- existence d'un court-circuit entre une phase de la tension alternative et le neutre, ou
- existence d'un court-circuit entre deux des trois phases de la tension alternative.
ce procédé comprenant les étapes suivantes :
- effectuer une mesure d'une grandeur électrique associée à la résistance de mesure,
- déterminer sur la base de cette mesure, notamment en comparant cette mesure à une valeur de référence, si le défaut existe ou non.

Selon le procédé, on peut effectuer une séquence de mesures de la grandeur électrique associée à la résistance de mesure et déterminer à l'aide de ces mesures l'existence de plusieurs desdits défauts, une mesure étant associée à la détermination d'un ou plusieurs desdits défauts.

Le procédé peut comprendre les étapes suivantes :
- effectuer une première mesure de la grandeur éélectrique associée à la résistance de mesure,
- déterminer sur la base de cette première mesure si le premier interrupteur est en état de court-circuit,
- lorsque le premier interrupteur n'est pas en état de court-circuit, effectuer une deuxième mesure de la grandeur électrique associée à la résistance de mesure,
- déterminer sur la base de cette deuxième mesure si le deuxième interrupteur est en état de court-circuit ou si l'un des interrupteurs du quatrième bras de commutation est en état de court-circuit,
- lorsque le deuxième interrupteur n'est pas en état de court-circuit ou que l'interrupteur du quatrième bras de commutation n'est pas en état de court-circuit, effectuer une troisième mesure de la grandeur électrique associée à la résistance de mesure,
- déterminer sur la base de cette troisième mesure si l'autre interrupteur du quatrième bras de commutation est en état de court-circuit,
- lorsque l'autre interrupteur du quatrième bras de commutation n'est pas en état de court-circuit, effectuer une quatrième mesure de la grandeur électrique associée à la résistance de mesure,
- déterminer sur la base de cette quatrième mesure si l'un des interrupteurs de l'onduleur/redresseur disposé entre un point milieu et l'une des bornes à potentiel continu est en état de court-circuit,
- lorsqu'aucun des interrupteurs de l'onduleur/redresseur disposé entre un point milieu et l'une des bornes à potentiel continu n'est en état de court-circuit, effectuer une cinquième mesure de la grandeur électrique associée à la résistance de mesure,
- déterminer sur la base de cette cinquième mesure si l'un des interrupteurs de l'onduleur/redresseur disposé entre un point milieu et l'autre des bornes à potentiel continu est en état de court-circuit,
- lorsqu'aucun des interrupteurs de l'onduleur/redresseur disposé entre un point milieu et l'autre des bornes à potentiel continu n'est en état de court-circuit, effectuer une sixième mesure de la grandeur électrique associée à la résistance de mesure,
- déterminer sur la base de cette sixième mesure si une phase de la tension alternative est en court-circuit avec le neutre,
- lorsqu'aucune phase de la tension alternative n'est en court-circuit avec le neutre, effectuer une septième mesure de la grandeur électrique associée à la résistance de mesure,
- déterminer sur la base de cette septième mesure si un court-circuit existe entre la première phase et la deuxième phase de la tension alternative,
- lorsqu'aucun court-circuit n'est détecté entre la première phase et la deuxième phase de la tension alternative, effectuer une huitième mesure de la grandeur électrique associée à la résistance de mesure,
- déterminer sur la base de cette huitième mesure si un court-circuit existe entre la première phase et la troisième phase de la tension alternative,
- lorsqu'aucun court-circuit n'est détecté entre la première phase et la troisième phase de la tension alternative, effectuer une neuvième mesure de la grandeur électrique associée à la résistance de mesure,
- déterminer sur la base de cette neuvième mesure si un court-circuit existe entre la deuxième phase et la troisième phase de la tension alternative.

Les étapes du procédé peuvent être effectuées selon l'ordre dans lequel elles viennent d'être exposées.

L'invention pourra être mieux comprise à la description qui va suivre d'un exemple non-limitatif de mise en oeuvre de celle-ci et à l'examen du dessin annexé, sur lequel :
[Fig.1] représente de façon schématique le circuit électrique d'un composant électronique 1 pour la charge d'une unité de stockage d'énergie électrique selon un exemple de mise en oeuvre de l'invention,
[Fig.2] est un diagramme représentant les différents défauts dont l'existence peut être détectées dans le composant de la figure 1, et
[Fig.3] représentant les étapes effectuées lors de la détection de l'existence des défauts de la figure 2.

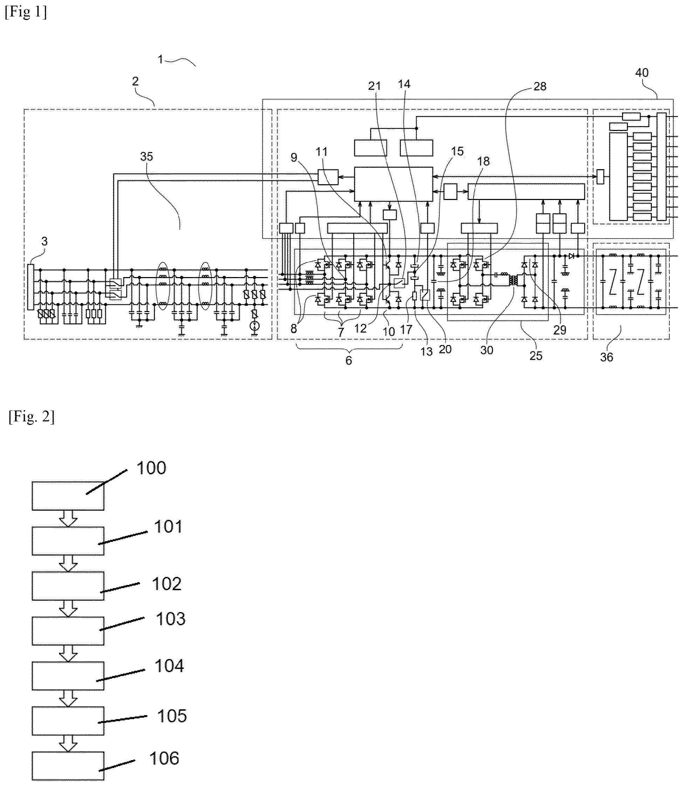

On a représenté sur la figure 1 un exemple de circuit électrique 2 d'un composant électronique 1 pour la charge d'une unité de stockage d'énergie électrique, encore appelé « chargeur ». L'unité de stockage d'énergie électrique est ici une batterie utilisée pour l'alimentation électrique d'une machine électrique de propulsion de véhicule. Cette batterie présente par exemple une tension nominale supérieure à 60V, notamment à 300V, notamment à 400V, notamment à 800V, voire à 1000V.

Le réseau électrique est par exemple un réseau triphasé véhiculant une tension à une première fréquence qui est de 50Hz ou 60Hz et dont la valeur efficace est de 230V ou 240V. Le réseau électrique est connecté au circuit électrique 2 par l'intermédiaire d'un connecteur 3 représenté sur la figure 1 de manière schématique.

Le circuit électrique 2 comprend, dans cet exemple :
- un onduleur/redresseur 6, comprenant trois bras de commutation 7 montés en parallèle, chaque bras de commutation 7 comprenant deux interrupteurs 8 disposés de part et d'autre d'un point milieu 9 apte à être connecté à une phase respective de la tension alternative,
- un quatrième bras de commutation 10 monté en parallèle des bras de commutation 7, ce quatrième bras de commutation 10 comprenant deux interrupteurs 11 disposés de part et d'autre d'un quatrième point milieu 12 apte à être connecté au neutre du réseau électrique, et
- une branche 13 montée en parallèle desdits bras de commutation 7 et 10, comprenant deux condensateurs 14 disposés de part et d'autre d'un cinquième point milieu 15, et une résistance de mesure 17, montée en série avec l'un des condensateurs 14. La résistance de mesure 17 est ici une thermistance à coefficient de température positif, encore appelée « PTC » en anglais.

Tous les interrupteurs 8 sont ici des transistors MOSFET et les interrupteurs 11 sont des transistors IGBT.

On constate que la branche 13 et les bras de commutation 7 et 10 sont montés entre deux bornes à potentiel continu. On constate également dans l'exemple considéré :
- que la résistance de mesure 17 est montée en série entre la masse et le condensateur 14 disposé entre le cinquième point milieu 15 et la masse, et
- qu'un premier interrupteur 20 est monté en parallèle de cette résistance de mesure 17.

Le quatrième point milieu 12 est également relié au cinquième point milieu 15 par l'intermédiaire d'un deuxième interrupteur 21.

Le premier interrupteur 20 et le deuxième interrupteur 21 sont ici des relais électrotechniques, En variante, d'autres exemples sont possibles, par exemple l'emploi de relais statiques à base de coupleurs optiques et/ou de transistors MOSFET et/ou de transistors IGBT.

Toujours dans l'exemple de la figure 1, un autre condensateur 18 est monté en parallèle de la branche 13.

Le circuit électrique 2 comprend encore dans l'exemple de la figure 1 un convertisseur DC/DC 25. Ce convertisseur DC/DC 25 comprend ici de façon connue deux convertisseurs DC/AC 28 et 29. On constate sur la figure 1 que le convertisseur DC/AC 28 est ici réversible, utilisant des interrupteurs bidirectionnels étant des transistors MOSFET, alors que le convertisseur DC/AC 29 est unidirectionnel, étant ici un redresseur à diodes. Un transformateur d'isolation galvanique 30 est disposé entre ces deux convertisseurs DC/AC 28 et 29. Ce convertisseur DC/DC est par exemple résonant, étant de type LLC ou CLLC, entre autres.

Comme représenté sur la figure 1, un étage de filtrage 35 du courant alternatif peut être prévu, cet étage de filtrage 35 étant ici disposé en série entre le connecteur 3 et l'onduleur/redresseur 6. Cet étage de filtrage 35 permet notamment lorsque la tension alternative est polyphasée, un filtrage du courant de mode commun et/ou un filtrage du courant différentiel. Comme représenté, des relais peuvent être présents, pour permettre le basculement d'un mode triphasé vers un mode monophasé, et vice versa.

Le cas échéant, et comme représenté sur la figure 1, un autre étage de filtrage 36 du courant continu peut être présent, étant alors disposé en série entre le convertisseur DC/DC 25 et l'unité de stockage d'énergie électrique, comme représenté sur la figure 1.

Le composant 1 est avantageusement dépourvu de fusible.

Le composant 1 comprend une unité de contrôle 40 dont le rôle va être décrit ci-après. Cette unité de contrôle 40 est par exemple réalisée à l'aide de plusieurs modules, comme on peut le voir sur la figure 1. Cette unité de contrôle 40 comprend par exemple des microcon-trôleurs et/ou des circuits intégrés.

Dans l'exemple de la figure 2, une basse tension est disponible lors d'un état 100 aux bornes des bras de commutation 7 et 10. Cette tension, non obtenue via le connecteur 3, est obtenue à partir de l'alimentation de l'unité de contrôle 40 et a une valeur comprise entre 12V et 24V, par exemple 18V ou 20V. La tension aux bornes de la résistance de mesure 17 peut être mesurée par l'unité de contrôle plusieurs fois et ces mesures peuvent permettre de déterminer :
- selon 101 si le premier interrupteur 20 est en état de court-circuit,
- selon 102 si le deuxième interrupteur 21 est en état de court-circuit et si l'un des interrupteurs 11 du quatrième bras de commutation 10 est en court-circuit,
- selon 103 si l'un des interrupteurs 8 d'un des bras de commutation 7 de l'onduleur/redresseur 6 est en état de court-circuit,
- selon 104 s'il existe un court-circuit entre une phase de la tension alternative et le neutre, et
- selon 105 s'il existe un court-circuit entre deux des trois phases de la tension alternative.

On peut ensuite selon 106 établir un diagnostic sur l'aptitude du composant 1 à être branché au réseau électrique.

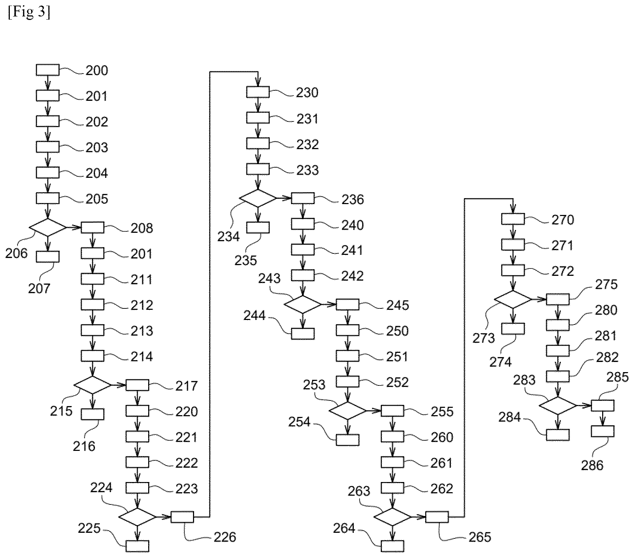

Les différentes étapes permettant d'établir ce diagnostic vont maintenant être décrites en référence à la figure 3. Pour réaliser ces étapes, l'unité de contrôle 40 effectue dans l'exemple considéré une séquence de mesures de la tension aux bornes de la résistance de mesure 17 et elle détermine, à l'aide de ces mesures, l'existence ou non de plusieurs de ces défauts, une mesure étant associée à la détermination d'un ou plusieurs desdits défauts.

La mesure est par exemple comparée par l'unité de contrôle 40 à une valeur de référence et, selon le résultat de cette comparaison, l'unité de contrôle 40 détermine si le défaut existe ou non.

Dans l'exemple de la figure 3, selon une étape d'initialisation 200, la tension aux bornes de la résistance de mesure 17 est mesurée pour obtenir selon une étape 201 une première valeur de référence, sans application d'une tension externe. Lors de l'étape 202, l'unité de contrôle 40 commande l'ouverture du premier interrupteur 20 disposé en parallèle de la résistance de mesure 17. Lors de l'étape 203, le dispositif de contrôle commande un interrupteur non représenté sur la figure 1 de manière à fournir une tension continue provenant de l'alimentation de l'unité de contrôle 40 aux bornes de la branche 13. Cette tension continue a ici une valeur de 18V. Une temporisation, par exemple d'1ms est appliquée selon l'étape 204.

Lors de l'étape 205, on mesure la tension aux bornes de la résistance de mesure 17, cette mesure étant encore appelée « première mesure » plus haut. Lors de l'étape 206, l'unité de contrôle détermine si la valeur de tension mesurée lors de l'étape 205 est la même ou non que celle mesurée lors de l'étape 201. En cas d'égalité, l'unité de contrôle déduit lors de l'étape 207 que le premier interrupteur 20 est en état de court-circuit et elle envoie un message d'impossibilité de connecter le connecteur 3 au réseau électrique. En cas de non-égalité, l'unité de contrôle déduit lors de l'étape 208 que le premier interrupteur 20 n'est pas en état de court-circuit. Les étapes 207 et 208 terminent la détection par l'unité de contrôle 40 d'un état de court-circuit du premier interrupteur 20. Lorsque l'étape 208 est effectuée, l'unité de contrôle peut procéder au test d'un état de court-circuit du deuxième interrupteur 21 selon les étapes 210 à 217.

Lors de l'étape 210, une temporisation, par exemple de 600ms est appliquée. Cette étape 210 permet une décharge de la tension aux bornes de la résistance de mesure 17. Lors de l'étape 211 une mesure de la tension aux bornes de la résistance de mesure 17 est effectuée pour établir une mesure de référence. Lors de l'étape 212, l'unité de contrôle 40 commande la fermeture de l'interrupteur 11 disposé entre la masse et le quatrième point milieu 12. Lors de l'étape 213, une temporisation, par exemple de 1ms est appliquée. Lors de l'étape 214, une mesure de la tension aux bornes de la résistance de mesure 17 est effectuée par l'unité de contrôle 40, cette mesure étant encore appelée « deuxième mesure » plus haut. Lors de l'étape 215, l'unité de contrôle 40 détermine si la valeur de tension mesurée lors de l'étape 214 est la même ou non que celle mesurée lors de l'étape 211. En cas de non-égalité, l'unité de contrôle déduit lors de l'étape 216 que l'interrupteur 11 disposé entre le quatrième point milieu 12 et la borne au potentiel continu positif est en état de court-circuit ou que le deuxième interrupteur 21 est en état de court-circuit et elle envoie un message d'impossibilité de connecter le connecteur 3 au réseau électrique. En cas d'égalité, l'unité de contrôle déduit lors de l'étape 217 que le deuxième interrupteur 21 n'est pas en état de court-circuit. Les étapes 216 et 217 terminent la détection par l'unité de contrôle 40 d'un état de court-circuit du deuxième interrupteur 21. Lorsque l'étape 217 est effectuée, l'unité de contrôle peut procéder au test d'un état de court-circuit de l'interrupteur 11 disposé entre la masse et le quatrième point milieu 12 selon les étapes 220 à 226.

Lors de l'étape 220, une mesure de la tension aux bornes de la résistance de mesure 17 est effectuée pour établir une mesure de référence. Lors de l'étape 221, l'unité de contrôle 40 commande la fermeture de l'interrupteur 11 disposé entre la borne au potentiel continu positif et le quatrième point milieu 12. Lors de l'étape 222, une temporisation, par exemple de 1ms est appliquée. Lors de l'étape 223, une mesure de la tension aux bornes de la résistance de mesure 17 est effectuée par l'unité de contrôle 40, cette mesure étant encore appelée « troisième mesure » plus haut. Lors de l'étape 224, l'unité de contrôle 40 détermine si la valeur de tension mesurée lors de l'étape 224 est la même ou non que celle mesurée lors de l'étape 221. En cas de non-égalité, l'unité de contrôle déduit lors de l'étape 225 que l'interrupteur 11 disposé entre la masse et le quatrième point milieu 12 est en état de court-circuit et elle envoie un message d'impossibilité de connecter le connecteur 3 au réseau électrique. En cas d'égalité, l'unité de contrôle déduit lors de l'étape 226 que l'interrupteur 11 disposé entre la masse et le quatrième point milieu 12 n'est pas en état de court-circuit. Les étapes 225 et 226 terminent la détection par l'unité de contrôle 40 d'un état de court-circuit de l'interrupteur 11 disposé entre la masse et le quatrième point milieu 12. Lorsque l'étape 226 est effectuée, l'unité de contrôle peut procéder au test d'un état de court-circuit des interrupteurs 8 de l'onduleur/redresseur 6 disposé entre un point milieu 9 et l'une des bornes à potentiel continu selon les étapes 230 à 236.

Lors de l'étape 230, une mesure de la tension aux bornes de la résistance de mesure 17 est effectuée pour établir une mesure de référence. Lors de l'étape 231, l'unité de contrôle 40 commande la fermeture de tous les interrupteurs 8 disposés entre un point milieu 9 et la masse. Lors de l'étape 232, une temporisation, par exemple de 1ms est appliquée. Lors de l'étape 233, une mesure de la tension aux bornes de la résistance de mesure 17 est effectuée par l'unité de contrôle 40, cette mesure étant encore appelée « quatrième mesure » plus haut. Lors de l'étape 234, l'unité de contrôle 40 détermine si la valeur de tension mesurée lors de l'étape 233 est la même ou non que celle mesurée lors de l'étape 230. En cas de non-égalité, l'unité de contrôle déduit lors de l'étape 235 que l'un des interrupteurs 8 disposés entre le potentiel continu positif et un point milieu 9 est en état de court-circuit et elle envoie un message d'impossibilité de connecter le connecteur 3 au réseau électrique. En cas d'égalité, l'unité de contrôle déduit lors de l'étape 236 qu'aucun des interrupteurs 8 disposés entre le potentiel continu positif et un point milieu 9 n'est en état de court-circuit. Les étapes 235 et 236 terminent la détection par l'unité de contrôle 40 d'un état de court-circuit d'un des interrupteurs 8 disposés entre un point milieu et le potentiel continu positif. Lorsque l'étape 236 est effectuée, l'unité de contrôle peut procéder au test d'un état de court-circuit des interrupteurs 8 de l'onduleur/redresseur 6 disposés entre un point milieu 9 et l'autre des bornes à potentiel continu, ici la masse, selon les étapes 240 à 245.

Lors de l'étape 240, une mesure de la tension aux bornes de la résistance de mesure 17 est effectuée pour établir une mesure de référence. Lors de l'étape 241, l'unité de contrôle 40 commande la fermeture de tous les interrupteurs 8 disposés entre un point milieu 9 et le potentiel continu positif. Lors de l'étape 242, une temporisation, par exemple de 1ms est appliquée. Lors d'une étape non représentée, une mesure de la tension aux bornes de la résistance de mesure 17 est effectuée par l'unité de contrôle 40, cette mesure étant encore appelée « cinquième mesure » plus haut. Lors de l'étape 243, l'unité de contrôle 40 détermine si la valeur de tension qui vient d'être mesurée est la même ou non que celle mesurée lors de l'étape 240. En cas de non-égalité, l'unité de contrôle déduit lors de l'étape 244 que l'un des interrupteurs 8 disposés entre la masse et un point milieu 9 est en état de court-circuit et elle envoie un message d'impossibilité de connecter le connecteur 3 au réseau électrique. En cas d'égalité, l'unité de contrôle déduit lors de l'étape 245 qu'aucun des interrupteurs 8 disposés entre la masse et un point milieu 9 n'est en état de court-circuit. Les étapes 244 et 245 terminent la détection par l'unité de contrôle 40 d'un état de court-circuit d'un des interrupteurs 8 disposés entre un point milieu et la masse. Lorsque l'étape 245 est effectuée, l'unité de contrôle 40 peut procéder au test de l'existence d'un court-circuit entre une phase de la tension alternative et le neutre selon les étapes 250 à 255.

Lors de l'étape 250, une mesure de la tension aux bornes de la résistance de mesure 17 est effectuée pour établir une mesure de référence. Lors de l'étape 251, l'unité de contrôle 40 commande la fermeture de tous les interrupteurs 8 disposés entre un point milieu 9 et le potentiel continu positif et l'ouverture de l'interrupteur 11 disposé entre le quatrième point milieu 12 et la masse. Lors de l'étape 252, une temporisation, par exemple de 1ms est appliquée. Lors d'une étape non représentée sur la figure 3, une mesure de la tension aux bornes de la résistance de mesure 17 est effectuée par l'unité de contrôle 40, cette mesure étant encore appelée « sixième mesure » plus haut. Lors de l'étape 253, l'unité de contrôle 40 détermine si la valeur de tension qui vient d'être mesurée est la même ou non que celle mesurée lors de l'étape 250. En cas de non-égalité, l'unité de contrôle déduit lors de l'étape 254 qu'il existe un court-circuit entre l'une des phases et le neutre et elle envoie un message d'impossibilité de connecter le connecteur 3 au réseau électrique. En cas d'égalité, l'unité de contrôle déduit lors de l'étape 255 qu'aucune phase n'est en court-circuit avec le neutre. Les étapes 254 et 255 terminent la détection par l'unité de contrôle 40 d'un court-circuit entre une phase et le neutre. Lorsque l'étape 255 est effectuée, l'unité de contrôle 40 peut procéder au test de l'existence d'un court-circuit entre deux phases de la tension alternative selon les étapes 260 à 265, 270 à 275 et 280 à 285.

Les étapes 260 à 265 se rapportent à l'existence d'un court-circuit entre la première phase et la deuxième phase de la tension alternative, les étapes 270 à 275 se rapportent à l'existence d'un court-circuit entre la première phase et la troisième phase de la tension alternative et les étapes 280 à 285 se rapportent à l'existence d'un court-circuit entre la deuxième phase et la troisième phase de la tension alternative.

Lors de l'étape 260, une mesure de la tension aux bornes de la résistance de mesure 17 est effectuée pour établir une mesure de référence. Lors de l'étape 261, l'unité de contrôle 40 commande la fermeture de l'interrupteur 8 du bras de commutation 7 pour la première phase disposé entre le point milieu 9 de ce bras 7 et la borne au potentiel continu positif, et la fermeture de l'interrupteur 8 du bras de commutation 7 pour la deuxième phase disposé entre le point milieu 9 de ce bras 7 et la masse. Lors de l'étape 262, une temporisation, par exemple de 1ms est appliquée. Lors d'une étape non représentée sur la figure 3, une mesure de la tension aux bornes de la résistance de mesure 17 est effectuée par l'unité de contrôle 40, cette mesure étant encore appelée « septième mesure » plus haut. Lors de l'étape 263, l'unité de contrôle 40 détermine si la valeur de tension qui vient d'être mesurée est la même ou non que celle mesurée lors de l'étape 260. En cas de non-égalité, l'unité de contrôle déduit lors de l'étape 264 qu'il existe un court-circuit entre la première phase et la deuxième phase et elle envoie un message d'impossibilité de connecter le connecteur 3 au réseau électrique. En cas d'égalité, l'unité de contrôle déduit lors de l'étape 265 qu'aucun court-circuit n'existe entre ces deux phases. Les étapes 264 et 265 terminent la détection par l'unité de contrôle 40 d'un court-circuit entre la première phase et la deuxième phase. Lorsque l'étape 265 est effectuée, l'unité de contrôle 40 peut procéder au test de l'existence d'un court-circuit entre la première phase et la troisième phase selon les étapes 270 à 275.

Lors de l'étape 270, une mesure de la tension aux bornes de la résistance de mesure 17 est effectuée pour établir une mesure de référence. Lors de l'étape 271, l'unité de contrôle 40 commande la fermeture de l'interrupteur 8 du bras de commutation 7 pour la première phase disposé entre le point milieu 9 de ce bras 7 et la borne au potentiel continu positif, et la fermeture de l'interrupteur 8 du bras de commutation 7 pour la troisième phase disposé entre le point milieu 9 de ce bras 7 et la masse. Lors de l'étape 272, une temporisation, par exemple de 1ms est appliquée. Lors d'une étape non représentée sur la figure 3, une mesure de la tension aux bornes de la résistance de mesure 17 est effectuée par l'unité de contrôle 40, cette mesure étant encore appelée « huitième mesure » plus haut. Lors de l'étape 273, l'unité de contrôle 40 détermine si la valeur de tension qui vient d'être mesurée est la même ou non que celle mesurée lors de l'étape 270. En cas de non-égalité, l'unité de contrôle déduit lors de l'étape 274 qu'il existe un court-circuit entre la première phase et la troisième phase et elle envoie un message d'impossibilité de connecter le connecteur 3 au réseau électrique. En cas d'égalité, l'unité de contrôle déduit lors de l'étape 275 qu'aucun court-circuit n'existe entre ces deux phases. Les étapes 274 et 275 terminent la détection par l'unité de contrôle 40 d'un court-circuit entre la première phase et la troisième phase. Lorsque l'étape 275 est effectuée, l'unité de contrôle 40 peut procéder au test de l'existence d'un court-circuit entre la deuxième phase et la troisième phase selon les étapes 280 à 285.

Lors de l'étape 280, une mesure de la tension aux bornes de la résistance de mesure 17 est effectuée pour établir une mesure de référence. Lors de l'étape 281, l'unité de contrôle 40 commande la fermeture de l'interrupteur 8 du bras de commutation 7 pour la deuxième phase disposé entre le point milieu 9 de ce bras 7 et la borne au potentiel continu positif, et la fermeture de l'interrupteur 8 du bras de commutation 7 pour la troisième phase disposé entre le point milieu 9 de ce bras 7 et la masse. Lors de l'étape 282, une temporisation, par exemple de 1ms est appliquée. Lors d'une étape non représentée sur la figure 3, une mesure de la tension aux bornes de la résistance de mesure 17 est effectuée par l'unité de contrôle 40, cette mesure étant encore appelée « neuvième mesure » plus haut. Lors de l'étape 283, l'unité de contrôle 40 détermine si la valeur de tension qui vient d'être mesurée est la même ou non que celle mesurée lors de l'étape 280. En cas de non-égalité, l'unité de contrôle déduit lors de l'étape 284 qu'il existe un court-circuit entre la deuxième phase et la troisième phase et elle envoie un message d'impossibilité de connecter le connecteur 3 au réseau électrique. En cas d'égalité, l'unité de contrôle déduit lors de l'étape 285 qu'aucun court-circuit n'existe entre ces deux phases. Les étapes 284 et 285 terminent la détection par l'unité de contrôle 40 d'un court-circuit entre la deuxième phase et la troisième phase. Lorsque l'étape 285 est effectuée, l'unité de contrôle 40 peut passer à l'étape 286 selon laquelle elle détermine qu'il n'y aucun des défauts précités qui existe et que le connecteur 3 peut être branché au réseau électrique.

L'ensemble des opérations de test décrites en référence à la figure 3 peut présenter une durée cumulée inférieure à 1 seconde, par exemple inférieure à 0,7s.

L'invention n'est pas limitée à ce qui a été décrit en référence aux figures.

D'autres emplacements sont possibles pour la résistance de mesure 17, par exemple un montage en série de cette résistance de mesure 17 avec le condensateur 14 disposé entre le potentiel continu positif et le cinquième point milieu 15. Un emplacement de cette résistance de mesure 17 ailleurs qu'en série avec un des condensateurs 14 est possible.

Par ailleurs, d'autres mesures de la tension aux bornes de la résistance de mesure peuvent être effectuées pour détecter un état en court-circuit d'un des interrupteurs du convertisseur DC/AC 28 du convertisseur DC/DC25. En variante, on détecte autrement l'absence de court-circuit associé au convertisseur DC/AC 28 en l'absence de fusible, par exemple par des shunts.

Par ailleurs encore, l'invention ne requiert pas d'obtenir une mesure de référence pour la tension aux bornes de la résistance de mesure 17 à chaque test pour déterminer l'existence d'un des défauts précités. A titre d'exemple, seule l'étape 201 est effectuée et la mesure de référence qui y est obtenue est conservée pour tout ou partie des autres tests, de sorte que les étapes 211 et/ou 220 et/ou 230 et/ou 240 et/ou 250 et/ou 260 et/ou 270 et/ou 280 ne sont alors pas effectuées.

## Revendications

1. Composant électronique (1) pour la charge d'une unité de stockage d'énergie électrique, comprenant :
- un connecteur (3) apte à être branché à un réseau électrique apte à fournir une tension alternative triphasée,
- un onduleur/redresseur (6), comprenant trois bras de commutation (7) montés en parallèle, chaque bras de commutation (7) comprenant deux interrupteurs (8) disposés de part et d'autre d'un point milieu (9) apte à être connecté à une phase respective de la tension alternative,
- un quatrième bras de commutation (10) monté en parallèle des bras de commutation (7) de l'onduleur/redresseur, ce quatrième bras de commutation (10) comprenant deux interrupteurs (11) disposés de part et d'autre d'un quatrième point milieu (12) apte à être connecté au neutre du réseau électrique, et
- une branche (13) montée en parallèle desdits bras de commutation (7, 10), comprenant deux condensateurs (14) disposés de part et d'autre d'un cinquième point milieu (15), et une résistance de mesure (17), montée en série avec l'un des condensateurs (14),
la branche (13) et les bras de commutation (7, 10) étant montés entre deux bornes à potentiel continu,
**caractérisé par le fait qu'**un premier interrupteur (20) est monté en parallèle de la résistance de mesure (17), ce premier interrupteur (20) formant notamment un interrupteur de pré-charge tel qu'un relais de pré-charge, et qu'un deuxième interrupteur (21) est monté en série entre le quatrième (12) et le cinquième (15) point milieu.

2. Composant selon la revendication 1, la résistance de mesure (17) étant montée en série avec le condensateur (14) disposé entre le cinquième point milieu (15) et celle des bornes à potentiel continu étant la masse.

3. Composant selon la revendication 1 ou 2, chacun du premier (20) et du deuxième (21) interrupteur étant un relais électrotechnique.

4. Composant selon l'une quelconque des revendications précédentes, comprenant un convertisseur DC/DC (25) monté en cascade avec le quatrième bras de commutation (10) et la branche (13) comprenant les deux condensateurs (14) et la résistance de mesure (17).

5. Composant selon l'une quelconque des revendications précédentes, la résistance de mesure (17) étant une thermistance.

6. Composant selon l'une quelconque des revendications précédentes, comprenant une unité de contrôle (40) configurée pour :
- effectuer une mesure d'une grandeur électrique associée à la résistance de mesure (17), et
- déterminer à l'aide de cette mesure l'un des défauts suivants :
- état en court-circuit du premier interrupteur (20),
- état en court-circuit du deuxième interrupteur (21),
- état en court-circuit d'un des interrupteurs (11) du quatrième bras de commutation (10),
- état en court-circuit d'un des interrupteurs (8) d'un bras de commutation (7) de l'onduleur/redresseur (6),
- existence d'un court-circuit entre une phase de la tension alternative et le neutre, ou
- existence d'un court-circuit entre deux des phases de la tension alternative.

7. Composant selon la revendication 6, l'unité de contrôle (40) étant configurée pour :
- effectuer une séquence de mesures de la grandeur électrique associée à la résistance de mesure (17) et,
- déterminer à l'aide de ces mesures plusieurs desdits défauts, une mesure étant associée à la détermination d'un ou plusieurs desdits défauts.

8. Composant selon la revendication 7, l'unité de contrôle (40) étant configurée pour :
- effectuer une première mesure de la grandeur électrique associée à la résistance de mesure (17),
- déterminer sur la base de cette première mesure si le premier interrupteur (20) est en état de court-circuit,
- lorsque le premier interrupteur (20) n'est pas en état de court-circuit, effectuer une deuxième mesure de la grandeur électrique associée à la résistance de mesure (17),
- déterminer sur la base de cette deuxième mesure si le deuxième interrupteur (21) est en état de court-circuit ou si l'un des interrupteurs (11) du quatrième bras de commutation (10) est en état de court-circuit,
- lorsque le deuxième interrupteur (21) n'est pas en état de court-circuit ou que l'interrupteur (11) du quatrième bras de commutation (10) n'est pas en état de court-circuit, effectuer une troisième mesure de la grandeur électrique associée à la résistance de mesure (17),
- déterminer sur la base de cette troisième mesure si l'autre interrupteur (11) du quatrième bras de commutation (10) est en état de court-circuit,
- lorsque l'autre interrupteur (11) du quatrième bras de commutation (10) n'est pas en état de court-circuit, effectuer une quatrième mesure de la grandeur électrique associée à la résistance de mesure (17),
- déterminer sur la base de cette quatrième mesure si l'un des interrupteurs (8) de l'onduleur/redresseur (6) disposé entre un point milieu (9) et l'une des bornes à potentiel continu est en état de court-circuit,
- lorsqu'aucun des interrupteurs (8) de l'onduleur/redresseur (6) disposé entre un point milieu (9) et l'une des bornes à potentiel continu n'est en état de court-circuit, effectuer une cinquième mesure de la grandeur électrique associée à la résistance de mesure (17),
- déterminer sur la base de cette cinquième mesure si l'un des interrupteurs (8) de l'onduleur/redresseur (6) disposé entre un point milieu (9) et l'autre des bornes à potentiel continu est en état de court-circuit,
- lorsqu'aucun des interrupteurs (8) de l'onduleur/redresseur (6) disposé entre un point milieu (9) et l'autre des bornes à potentiel continu n'est en état de court-circuit, effectuer une sixième mesure de la grandeur électrique associée à la résistance de mesure (17),
- déterminer sur la base de cette sixième mesure si une phase de la tension alternative est en court-circuit avec le neutre,
- lorsqu'aucune phase de la tension alternative n'est en court-circuit avec le neutre, effectuer une septième mesure de la grandeur électrique associée à la résistance de mesure (17),
- déterminer sur la base de cette septième mesure si un court-circuit existe entre la première phase et la deuxième phase de la tension alternative,
- lorsqu'aucun court-circuit n'est détecté entre la première phase et la deuxième phase de la tension alternative, effectuer une huitième mesure de la grandeur électrique associée à la résistance de mesure (17),
- déterminer sur la base de cette huitième mesure si un court-circuit existe entre la première phase et la troisième phase de la tension alternative,
- lorsqu'aucun court-circuit n'est détecté entre la première phase et la troisième phase de la tension alternative, effectuer une neuvième mesure de la grandeur électrique associée à la résistance de mesure (17),
- déterminer sur la base de cette neuvième mesure si un court-circuit existe entre la deuxième phase et la troisième phase de la tension alternative.

9. Composant selon les revendications 4 et 6, l'unité de contrôle (40) étant configurée pour effectuer au moins une mesure additionnelle de la grandeur électrique associée à la résistance de mesure (17) pour déterminer l'état en court-circuit d'un interrupteur du convertisseur DC-DC (25).

10. Composant selon l'une quelconque des revendications 6 à 9, la grandeur électrique associée à la résistance de mesure (17) étant la tension aux bornes de cette résistance de mesure.

11. Composant selon l'une quelconque des revendications précédentes, comprenant un étage de filtrage (35) du courant alternatif disposé en série entre le connecteur (3) et l'onduleur/redresseur (6).

12. Composant selon l'une quelconque des revendications précédentes, comprenant un étage de filtrage (36) du courant continu apte à être disposé en série entre le convertisseur DC/DC (25) et l'unité de stockage d'énergie électrique.

13. Procédé, mis en oeuvre dans le composant selon l'une quelconque des revendications précédentes, de détection de l'un au moins des défauts suivants :
- état en court-circuit du premier interrupteur (20),
- état en court-circuit du deuxième interrupteur (21),
- état en court-circuit d'un des interrupteurs (11) du quatrième bras de commutation (10),
- état en court-circuit d'un des interrupteurs (8) d'un bras de commutation (7) de l'onduleur/redresseur (6),
- existence d'un court-circuit entre une phase de la tension alternative et le neutre, ou
- existence d'un court-circuit entre deux des trois phases de la tension alternative.
ce procédé comprenant les étapes suivantes :
- effectuer une mesure d'une grandeur électrique associée à la résistance de mesure (17),
- déterminer sur la base de cette mesure, notamment en comparant cette mesure à une valeur de référence, si le défaut existe ou non.

14. Procédé selon la revendication précédente, dans lequel la ou les détections sont effectuées alors qu'une tension, non obtenue par le connecteur (3), est appliquée aux bornes des bras de commutation (7, 11).

15. Procédé selon la revendication 14, la tension appliquée aux bornes des bras de commutation (7, 11) étant obtenue à partir de l'alimentation de l'unité de contrôle (40) et/ou ayant une valeur comprise entre 12V et 24V, par exemple égale à 18V ou 20V.
